(19) Europäisches Patentamt / European Patent Office / Office européen des brevets

(11) **EP 4 538 320 A1**

(12) **EUROPEAN PATENT APPLICATION**

(43) Date of publication:
**16.04.2025 Bulletin 2025/16**

(21) Application number: **24199698.2**

(22) Date of filing: **11.09.2024**

(51) International Patent Classification (IPC):
***C08K 3/04*** *(2006.01)* ***C08K 3/22*** *(2006.01)*
***C08K 3/32*** *(2006.01)* ***C08K 5/52*** *(2006.01)*
***C08K 7/06*** *(2006.01)* ***C08K 7/14*** *(2006.01)*
***C08L 23/12*** *(2006.01)*

(52) Cooperative Patent Classification (CPC):
(C-Sets available)
C08K 2003/2296; C08K 2003/323; C08K 2201/001;
C08K 2201/005; C08K 2201/016 (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.10.2023 JP 2023173568**

(71) Applicants:
- **MAZDA MOTOR CORPORATION**
  **Hiroshima 730-8670 (JP)**
- **Adeka Corporation**
  **Tokyo 116-0012 (JP)**

(72) Inventors:
- **YASUDA, Shuhei**
  **Aki-gun, Hiroshima, 730-8670 (JP)**
- **OGAWA, Junichi**
  **Aki-gun, Hiroshima, 730-8670 (JP)**
- **KATSUMA, Yuhei**
  **Tokyo, 116-0012 (JP)**
- **BANNO, Keisuke**
  **Tokyo, 116-0012 (JP)**
- **INAGAKI, Yohei**
  **Tokyo, 116-0012 (JP)**
- **SAKAI, Atsushi**
  **Tokyo, 116-0012 (JP)**
- **YONEZAWA, Yutaka**
  **Tokyo, 116-0012 (JP)**

(74) Representative: **Herrmann, Uwe**
**Lorenz Seidler Gossel**
**Rechtsanwälte Patentanwälte**
**Partnerschaft mbB**
**Widenmayerstraße 23**
**80538 München (DE)**

(54) **CONDUCTIVE RESIN COMPOSITION AND ELECTROMAGNETIC SHIELDING MATERIAL USING THE SAME**

(57) A conductive resin composition contains matrix resin, coke powder, carbon fiber, and a phosphorus-based flame retardant including (poly)phosphate. The volume mean particle diameter of the coke powder is not less than 1 μm and not more than 500 μm. The content of the coke powder in the conductive resin composition is not less than 5 mass% and not more than 17 mass%. The aspect ratio of the carbon fiber is not less than 3 and not more than 1700. The content of the carbon fiber in the conductive resin composition is not less than 0.5 mass% and not more than 5 mass%. The content of the phosphorus-based flame retardant in the conductive resin composition is not less than 10 mass%.

FIG.1

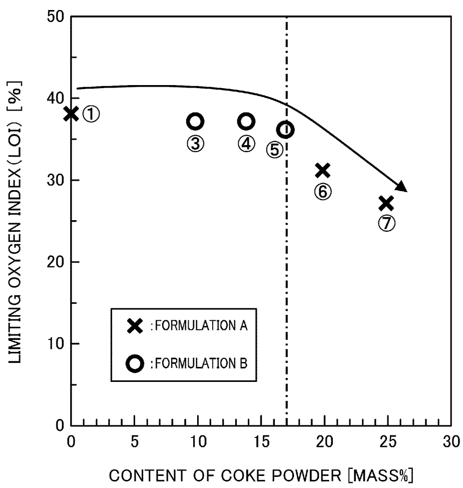




Processed by Luminess, 75001 PARIS (FR)

(Cont. next page)

(52) Cooperative Patent Classification (CPC): (Cont.)

C-Sets
**C08K 3/04, C08L 23/12;**
**C08K 3/22, C08L 23/12;**
**C08K 3/32, C08L 23/12;**
**C08K 5/5205, C08L 23/12;**
**C08K 7/06, C08L 23/12;**
**C08K 7/14, C08L 23/12**

## Description

CROSS-REFERENCE TO RELATED APPLICATIONS

This application claims priority to Japanese Patent Application No. 2023-173568 filed on October 5, 2023, the entire disclosure of which is incorporated by reference herein.

TECHNICAL FIELD

The present disclosure relates to a conductive resin composition and an electromagnetic shielding material using such a composition.

BACKGROUND ART

In recent years, an electrically conductive function has been imparted to covering materials used for automobile parts, electronic devices, and the like to shield electromagnetic waves and thereby prevent effects on human bodies and prevent misoperations of electronic devices. Specifically, for example, a covering material used for an upper cover of a battery pack for an electric vehicle is formed using a metal plate, thereby shielding an electromagnetic wave emitted from the battery pack.

There is a demand for forming such covering materials with resin to reduce the weight of automobiles, electronic devices, and the like. For example, in the field of automobiles, various types of techniques such as sensing the distance and the speed and sensing obstacles using electromagnetic waves have been implemented. In such techniques, it is required to shield unwanted electromagnetic waves with high precision to ensure correct sensing. Also, as the covering materials, it is important to have excellent mechanical properties such as high rigidity and also have excellent cost performance.

In view of the above, the present applicants proposed a conductive resin composition containing matrix resin, coke powder, and carbon fiber at desired content percentages and an electromagnetic shielding material using this composition (Japanese Unexamined Patent Publication No. 2021-161193). In the proposed conductive resin composition and electromagnetic shielding material, by increasing the contained amount of the coke powder while reducing the contained amount of the carbon fiber, excellent electromagnetic shielding performance and excellent mechanical properties can be exhibited and also cost reduction can be achieved.

CITATION LIST

PATENT DOCUMENTS

Patent Document 1: Japanese Unexamined Patent Publication No. 2021-161193

SUMMARY OF THE DISCLOSURE

TECHNICAL PROBLEMS

In general, an electromagnetic shielding material is required to be fire-resistant (flame-retardant). In the cited patent document, no examination has been made on flame retardancy. As a method of imparting flame retardancy to the electromagnetic shielding material, it is considered to blend a flame retardant into the conductive resin composition as the raw material of the electromagnetic shielding material. When the content percentage of the coke powder increases, however, the action/function of the flame retardant may be reduced, causing a failure in exhibiting desired flame retardancy.

An objective of the present disclosure is providing a conductive resin composition having both an excellent electromagnetic shielding property and flame retardancy while maintaining excellent mechanical properties and low cost, and an electromagnetic shielding material using such a composition.

SOLUTION TO THE PROBLEM

The present inventors have found that, when a foam-type flame retardant (e.g., a phosphorus-based flame retardant) is used, foaming of the flame retardant is reduced in a conductive resin composition containing a large amount of coke powder (e.g., 20 mass% or more), whereby the index of flame retardancy is significantly worsened. Based on the findings, the present disclosure aims at satisfying the required electromagnetic shielding property without increasing the

added amounts of coke powder and carbon fiber while avoiding decrease in flame retardancy due to the addition of coke powder (improving flame retardancy).

A conductive resin composition disclosed herein contains matrix resin, coke powder, carbon fiber, and a phosphorus-based flame retardant including (poly)phosphate. The volume mean particle diameter of the coke powder is not less than 1 μm and not more than 500 μm. The content of the coke powder in the conductive resin composition is not less than 5 mass% and not more than 17 mass%. The aspect ratio of the carbon fiber is not less than 3 and not more than 1700. The content of the carbon fiber in the conductive resin composition is not less than 0.5 mass% and not more than 5 mass%. The content of the phosphorus-based flame retardant in the conductive resin composition is not less than 10 mass%.

According to the above configuration, in the conductive resin composition, by setting the content of the phosphorus-based flame retardant including (poly)phosphate at 10 mass% or more, the coke powder and the carbon fiber as electrically conductive fillers (conductive materials) form an aggregation structure thereby forming a network in the matrix resin even when the content of the coke powder is not less than 5 mass% and not more than 17 mass%. This forms a conductive path through which electricity passes in the matrix resin, causing a percolation phenomenon in which the electrical conductivity dramatically rises. As a result, an excellent electromagnetic shielding property (electric field shielding property) can be exhibited. Also, by setting the content of the coke powder at not less than 5 mass% and not more than 17 mass%, lower than 20 mass%, foaming of the phosphorus-based flame retardant is prevented from decreasing, whereby excellent flame retardancy can be exhibited. Thus, by specifying the contents of the coke powder and the phosphorus-based flame retardant to fall within the above ranges, decrease in flame retardancy can be prevented, and also since the electromagnetic shielding property can be improved without increasing the content of the carbon fiber, low cost is maintained. In addition, with the formation of the network, excellent mechanical properties of the electromagnetic shielding material are maintained.

As used herein, an excellent electromagnetic shielding property indicates that the electric field shielding effect (SE) against electromagnetic waves having a frequency of 300 kHz to 3 MHz (more specifically, 1.7 MHz) used for ship communications, medium wave broadcasting (AM radio), beacons for ships and aircraft, and amateur radio, for example, is 45 dB (shield factor 99%) or more. The measured value of the electric field shielding effect indicates a value measured according to a KEC method (method of measuring the electromagnetic shielding effect developed by KEC Electronic Industry Development Center).

Also, as used herein, excellent flame retardancy indicates that the limiting oxygen index (LOI) measured according to JIS K 7201 is 36% or more.

In an embodiment of the conductive resin composition, the phosphorus-based flame retardant satisfies $8.0 \times 10^{-4} \leq F / N \leq 20.0$, $F \leq 21.0$ where F is a content (ppm) of iron element, and N is a content (ppm) of sodium element, in the phosphorus-based flame retardant, measured according to the following procedure:

mixing the phosphorus-based flame retardant as a sample in a 1M nitric acid aqueous solution, agitating the solution for 24 hours at room temperature 25°C, and then subjecting the solution to a membrane filter, to prepare a measurement solution; and

measuring contents of the iron element and the sodium element in the resultant measurement solution by ICP optical emission spectroscopy. According to this configuration, the phosphorus-based flame retardant including (poly) phosphate is specified.

The phosphorus-based flame retardant may include at least a pyrophosphate, among the group of (poly) phosphate consisting of orthophosphates, pyrophosphates, and polyphosphates in which n is 3 or more or r is 3 or more, expressed by General Formula (1),

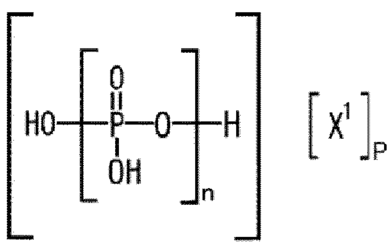

(1)

where n denotes a numeric from 1 to 100, $X^1$ represents ammonia or a triazine derivative expressed by General Formula (2) below, and p is a numeric satisfying a relational expression, $0 < p \leq n + 2$,

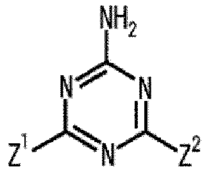

(2)

where $Z^1$ and $Z^2$, which may be the same or different from each other, represent a group selected from the group consisting of a $-NR^5R^6$ group, a hydroxyl group, a mercapto group, a straight-chain or branched alkyl group having 1 to 10 carbon atoms, a straight-chain or branched alkoxy group having 1 to 10 carbon atoms, a phenyl group, and a vinyl group, and $R^5$ and $R^6$ independently represent a hydrogen atom, a straight-chain or branched alkyl group having 1 to 6 carbon atoms, or a methylol group, or expressed by General Formula (3),

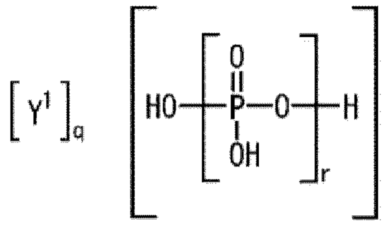

(3)

where r denotes a numeric from 1 to 100, $Y^1$ represents $[R^1R^2N(CH_2)_mNR^3R^4]$, piperazine, or diamine including a piperazine ring, $R^1$, $R^2$, $R^3$, and $R^4$, which may be the same or different from one another, are each a hydrogen atom or a straight-chain or branched alkyl group having 1 to 5 carbon atoms, m is an integer from 1 to 10, and q is a numeric satisfying a relational expression, $0 < q \leq r + 2$. According to this configuration, the phosphorus-based flame retardant that includes (poly)phosphate and in which F and N satisfy the relational expression, $8.0 \times 10^{-4} \leq F / N \leq 20.0$, $F \leq 21.0$, is specified.

In an embodiment of the conductive resin composition, the content of the phosphorus-based flame retardant in the conductive resin composition is not more than 30 mass%. According this configuration, the flame retardancy can be obtained efficiently when the content of the coke powder is not less than 5 mass% and not more than 17 mass%.

In an embodiment, the conductive resin composition further contains a flame retardant aid, and the content of the flame retardant aid in the conductive resin composition is not less than 0.5 mass% and not more than 5 mass%. According to this configuration, with addition of the flame retardant aid, not only the flame retardancy is improved, but also the electromagnetic shielding property can be improved since the electrical conductivity of the flame retardant aid itself contributes to the formation of the conductive path.

In an embodiment of the conductive resin composition, the flame retardant aid is zinc oxide. According to this configuration, the flame retardant aid used together with the phosphorus-based flame retardant is specified.

In an embodiment, the conductive resin composition further contains a reinforcing filler, and the content of the reinforcing filler in the conductive resin composition is not less than 5 mass% and not more than 40 mass%. According to this configuration, since the aggregation of the coke powder is promoted with addition of the reinforcing filler, the electromagnetic shielding property can be improved. Note that, although the addition of the reinforcing filler changes the rigidity of the char, the influence thereof on the flame retardancy is small.

In an embodiment of the conductive resin composition, the reinforcing filler is at least one type selected from the group consisting of talc, calcium carbonate, glass fiber, aramid fiber, and basalt fiber. According to this configuration, the reinforcing filler is specified.

The electromagnetic shielding material disclosed herein uses the conductive resin composition described above. Therefore, the electromagnetic shielding material can exhibit both an excellent electromagnetic shielding property and flame retardancy while maintaining excellent mechanical properties and low cost.

## ADVANTAGES OF THE INVENTION

As described above, according to the present disclosure, it is possible to provide a conductive resin composition having both an excellent electromagnetic shielding property and flame retardancy while maintaining excellent mechanical properties and low cost, and an electromagnetic shielding material using such a composition.

## BRIEF DESCRIPTION OF THE DRAWINGS

FIG. 1 is a view showing the limiting oxygen index (LOI) of a "formulation A" (comparative resin composition) containing coke powder and a phosphorus-based flame retardant and a "formulation B" (conductive resin composition) containing coke powder, a phosphorus-based flame retardant, carbon fiber, and glass fiber, with respect to the content percentage of the coke powder.

FIG. 2 is a view showing the electric field shielding effect at a frequency of 1.7 MHz of the "formulation B" and a "formulation C" (comparative resin composition) containing coke powder and carbon fiber (containing no flame retardant), with respect to the content percentage of the coke powder.

FIG. 3 is a view showing the limiting oxygen index (LOI) of resin compositions containing coke powder by 0 mass% (containing no coke powder), 10 mass%, 20 mass%, and 25 mass%, a phosphorus-based flame retardant, and carbon fiber, with respect to the content percentage of the phosphorus-based flame retardant.

## DESCRIPTION OF EMBODIMENTS

An embodiment for carrying out the present disclosure will be described hereinafter with reference to the accompanying drawings. Note that the description of the preferred embodiment to follow is essentially mere illustration and by no means intended to limit the present disclosure, applications thereof, or uses thereof.

### <Conductive Resin Composition>

The conductive resin composition according to this embodiment contains matrix resin, coke powder, carbon fiber, and a phosphorus-based flame retardant. In other words, two-ingredient electrically conductive fillers and a flame retardant are added to the matrix resin. The conductive resin composition can be used as a molding material for an electromagnetic shielding material to be described later.

#### (Matrix Resin)

The matrix resin is a thermoplastic resin and/or a thermosetting resin. Examples of the thermoplastic resin include polystyrene, vinyl acetate, polyester, polyethylene, polypropylene, polyamide, rubber, and acrylic resins. Examples of the thermosetting resin include unsaturated polyester, phenol, epoxy, urethane, melamine, and alkyd resins. These types of matrix resin may be used alone, or two or more types may be used in combination. The matrix resin is preferably a thermoplastic resin from the viewpoint of easy moldability into the electromagnetic shielding material and recyclability. Among the thermoplastic resins, polypropylene (PP) is more preferable from the viewpoint of cost and mechanical properties. A commercially available resin material can be used as the matrix resin.

The content of the matrix resin in the conductive resin composition is preferably 30 mass% or more, more preferably 35 mass% or more, from the viewpoint of improving moldability. Also, the content of the matrix resin is preferably 50 mass% or less from the viewpoint of securing both the electromagnetic shielding property and flame retardancy.

#### (Coke Powder)

The coke powder (hereinafter also called "Coke") is crushed particles of a carbon material (Coke) obtained by dry distillation of coal or coking (thermal polymerization) of petroleum and coal-based heavy oil. The coke powder is a relatively inexpensive material compared with carbon black and artificial graphite, and has the same level of electrical conductivity as carbon black and carbon fiber. As the coke powder, commercially available coke powder can be used. Pitch coke powder may also be used as the coke powder. The pitch coke powder is an easily graphitizable carbon material obtained by burning at high temperature soft pitch (SOP) separated from coal tar, which is a by-product of dry distillation (carbonization) of coal, and removing a volatile matter content, and is expected to improve the electrical conductivity.

Examples of the shape of the coke powder include spherical, elliptical, flake-like, fibrous, and dendroid shapes. Coke powder having a single shape may be used, or coke powder having different shapes may be used in combination.

The volume mean particle diameter (MV) of the coke powder is not less than 1 $\mu$m and not more than 500 $\mu$m. Preferably, the volume mean particle diameter of the coke powder is 10 $\mu$m or more from the viewpoint of improving the electromagnetic shielding property, and 50 $\mu$m or less from the viewpoint of improving moldability. Note that the volume mean particle diameter as used herein refers to a mean diameter weighted by the volume measured by a laser diffraction/scattering method.

The content of the coke powder in the conductive resin composition is not less than 5 mass% and not more than 17 mass%. The content of the coke powder is 5 mass% or more, preferably 8 mass% or more, more preferably 12 mass% or more, from the viewpoint of improving the electromagnetic shielding property. Also, the content of the coke powder is 17 mass% or less, preferably 15 mass% or less, from the viewpoint of improving moldability, reducing the cost, and improving flame retardancy.

In the relationship between the content of the coke powder and the flame retardancy, as shown in FIG. 1 (also see Table 1), the limiting oxygen index (LOI) little changes in the range of 0 to 17 mass%, but decreases sharply when the content exceeds 17 mass%. This indicates that the content of the coke powder "17 mass%" is the point of change of the flame retardancy (effect). Note that the numbers in FIG. 1 and FIG. 2 to follow correspond to the "Number in Figure" in Table 1.

In the relationship between the content of the coke powder and the electromagnetic shielding property, as shown in FIG. 2 (also see Table 1), in order to ensure a sufficient electric field shielding effect (e.g., 45 dB or more) against an electromagnetic wave having a frequency of 1.7 MHz, the content of the coke powder needs to be "5 mass% or more." It is found that the "formulation B" (conductive resin composition) is significantly high in electromagnetic shielding property compared with the "formulation C" (comparative resin composition) containing no flame retardant. That is, by further adding a flame retardant to the combined conductive fillers of the coke powder and carbon fiber, the electromagnetic shielding property can be improved, and therefore the content of the coke powder can be widely reduced.

(Carbon Fiber)

As the carbon fiber (hereinafter also called "CF"), commercially available carbon fibers such as polyacrylonitrile (PAN), pitch, and cellulose carbon fibers, hydrocarbon-based vapor grown carbon fibers, and graphite fibers, for example, can be used. These types of carbon fiber may be used alone, or two or more types may be used in combination.

The mean fiber length (weight mean fiber length) of the carbon fiber is preferably 0.5 mm or more, more preferably 1 mm or more, still more preferably 2 mm or more, furthermore preferably 3 mm or more, from the viewpoint of improving the electromagnetic shielding property. Also, the mean fiber length of the carbon fiber is preferably 25 mm or less, more preferably 10 mm or less, from the viewpoint of improving moldability and mechanical properties. Among the types of carbon fiber, carbon fibers of long fiber specification having a mean fiber length of 2 mm or more are preferable from the viewpoint of further improving the electromagnetic shielding property.

Note that the mean fiber length as used herein refers to the mean value of fiber lengths of 100 or more fibers in a mold product extracted and measured. As a method of extracting fibers, an ashing method, for example, may be used.

The mean fiber diameter of the carbon fiber is preferably 3 μm or more, more preferably 6 μm or more, from the viewpoint of improving the electromagnetic shielding property. Also, the mean fiber diameter of the carbon fiber is preferably 12 μm or less, more preferably 10 μm or less, from the viewpoint of improving moldability and mechanical properties.

The mean fiber diameter as used herein refers to a mean diameter averaged by dividing the total value of the monofilament diameters of monofilaments constituting a fiber bundle by the number of monofilaments constituting the fiber bundle. The monofilament diameter refers to the average value of the maximum diameter and the minimum diameter of the cross-section of a monofilament obtained when the monofilament is cut in the direction perpendicular to the fiber axis direction. The shape of the cross-section of the fiber is not specifically limited and may be a perfect circle or an ellipse. The outer circumference of the cross-section of the fiber may have a wavy shape having asperities. Such a wavy shape is acceptable if only the height of asperities is about 10% or less of the monofilament diameter.

The aspect ratio of the carbon fiber is not less than 3 and not more than 1700. The aspect ratio of the carbon fiber is 3 or more, preferably 70 or more, more preferably 100 or more, still more preferably 300 or more, furthermore preferably 500 or more, from the viewpoint of improving the electromagnetic shielding property and mechanical properties. Also, the aspect ratio of the carbon fiber is 1700 or less, preferably 1000 or less, more preferably 600 or more, from the viewpoint of improving moldability. The aspect ratio as used herein refers to the ratio of the length of a fiber in the longitudinal direction (fiber axis direction) to the length thereof in the lateral direction orthogonal to the longitudinal direction. Also, the aspect ratio refers to a value measured by the laser diffraction/scattering method.

The content of the carbon fiber in the conductive resin composition is not less than 0.5 mass% and not more than 5 mass%. The content of the carbon fiber is 0.5 mass% or more, preferably 1 mass% or more, more preferably 2 mass% or more, from the viewpoint of improving the electromagnetic shielding property. Also, the content of the carbon fiber is 5 mass% or less, preferably 3 mass% or less, from the viewpoint of cost reduction.

The total of the contents of the coke powder and the carbon fiber in the conductive resin composition is preferably 5.5 mass% or more, more preferably 10 mass% or more, still more preferably 15 mass% or more, from the viewpoint of improving the electromagnetic shielding property. Also, the total of the contents of the coke powder and the carbon fiber is preferably 22 mass% or less from the viewpoint of improving moldability and mechanical properties and cost reduction.

(Phosphorus-based Flame Retardant)

The phosphorus-based flame retardant is a foam-type flame retardant. As the phosphorus-based flame retardant, a commercially available flame retardant can be used. The present inventors have found, after elaborate examination, that the expansion ratio of the phosphorus-based flame retardant decreases (foaming is reduced) with

addition of the coke powder, whereby the limiting oxygen index (LOI) greatly decreases. Also, the present inventors have found that, with addition of the coke powder, the decomposition temperature of the matrix resin containing conductive fillers shifts to a higher temperature and the decomposition temperature widely rises under an inert environment. From these findings, the mechanism of the decrease in flame retardancy due to addition of the coke powder is considered to be as follows: (1) since the decomposition temperature of the matrix resin containing conductive fillers largely rises under a burning environment, decomposition (foaming) of the phosphorus-based flame retardant starts first; (2) since the foaming of the phosphorus-based flame retardant starts in the state where the resin is still present around, the foam expansion ratio decreases due to the viscosity of the resin; and (3) as a result, the thermal conductivity of a heat insulating layer of the resin increases, whereby the decomposition of the resin is promoted and the flame retardancy decreases.

The phosphorus-based flame retardant is a phosphorus-based flame retardant including (poly)phosphate. The (poly)phosphoric acid as used herein refers to one of, or a mixture of, orthophosphoric acid, pyrophosphoric acid, and polyphosphoric acid having a degree of condensation of 3 or more. The (poly)phosphate may include two or more types of phosphates different in the degree of polymerization or the type of salt.

As the phosphorus-based flame retardant including (poly)phosphate, a phosphorus-based flame retardant satisfying $8.0 \times 10^{-4} \leq F / N \leq 20.0$, $F \leq 21.0$ where F is the content (ppm) of iron element, and N is the content (ppm) of sodium element, in the phosphorus-based flame retardant measured according to the following procedure, is preferable.

(Procedure)

An example of the procedure for measuring the content F (ppm) of iron element, and the content N (ppm) of sodium element, in the phosphorus-based flame retardant is as follows.

First, a sample of the phosphorus-based flame retardant is mixed in a 1M nitric acid aqueous solution, and the solution is agitated for 24 hours at room temperature 25°C and then subjected to a membrane filter, to prepare a measurement solution. For example, 50 mL to 100 mL of the 1M nitric acid aqueous solution may be added to 250 mg to 500 mg of the sample, to prepare the measurement solution.

Subsequently, the contents of iron element and sodium element in the resultant measurement solution are measured by ICP optical emission spectroscopy. A calibration curve is prepared in the range of 0 ppm to 0.5 ppm or in the range of 0.5 ppm to 10 ppm for both Fe and Na. At this time, which calibration curve to be used may be determined depending on the detection intensity of Fe and Na in the measurement solution, and when a content exceeds the above calibration curve range, the solution may be diluted with the 1M nitric acid aqueous solution to obtain a concentration falling within the calibration curve range before the measurement.

The upper limit of the content F of iron element in the phosphorus-based flame retardant measured according to the above procedure is preferably 21.0 ppm or less, more preferably 20.5 ppm or less, still more preferably 16.5 ppm or less, from the viewpoint of securing both the electromagnetic shielding property and flame retardancy. The lower limit of the content F is not specifically limited as long as Fe is contained, but may be 0.5 ppm or more, or 1.0 ppm or more, for example, from the viewpoint of improving flame retardancy.

The upper limit of the content N of sodium element in the phosphorus-based flame retardant measured according to the above procedure is preferably $5.1 \times 10^3$ ppm or less, more preferably $4.2 \times 10^3$ ppm or less, still more preferably $3.0 \times 10^3$ ppm or less, from the viewpoint of securing both the electromagnetic shielding property and flame retardancy. The lower limit of the content N is not specifically limited as long as Na is contained, but may be 0.1 ppm or more, or 0.5 ppm or more, for example.

The upper limit of the ratio of the content F (ppm) of iron element to the content N (ppm) of sodium element, F/N, in the phosphorus-based flame retardant measured according the above procedure is preferably 20.0 or less, more preferably 19.0 or less, still more preferably 18.0 or less, from the viewpoint of securing both the electromagnetic shielding property and flame retardancy. The lower limit of F/N is preferably $8.0 \times 10^{-4}$ or more, more preferably $9.0 \times 10^{-4}$ or more, still more preferably $1.0 \times 10^{-3}$ or more, from the viewpoint of improving flame retardancy.

As the phosphorus-based flame retardant including (poly)phosphate, in which the above F and N satisfy the relational expression, $8.0 \times 10^{-4} \leq F / N \leq 20.0$, $F \leq 21.0$, a phosphorus-based flame retardant including at least a pyrophosphate, among the (poly)phosphate group consisting of orthophosphates, pyrophosphates, and polyphosphates in which n is 3 or more or r is 3 or more, expressed by General Formula (1) or General Formula (3) below is preferable. These types of phosphorus-based flame retardant may be used alone, or two or more types may be used in combination.

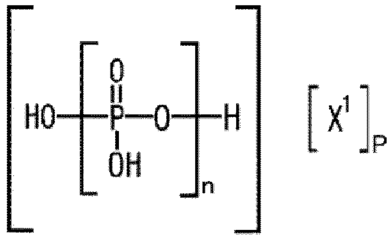

(1)

where n denotes a numeric from 1 to 100, $X^1$ represents ammonia or a triazine derivative expressed by General Formula (2) below, and p is a numeric satisfying the relational expression, $0 < p \leq n + 2$.

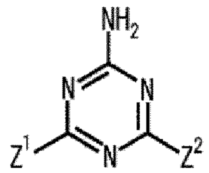

(2)

where $Z^1$ and $Z^2$, which may be the same or different from each other, each represent a group selected from the group consisting of a $-NR^5R^6$ group, a hydroxyl group, a mercapto group, a straight-chain or branched alkyl group having 1 to 10 carbon atoms, a straight-chain or branched alkoxy group having 1 to 10 carbon atoms, a phenyl group, and a vinyl group, and $R^5$ and $R^6$ independently represent a hydrogen atom, a straight-chain or branched alkyl group having 1 to 6 carbon atoms, or a methylol group.

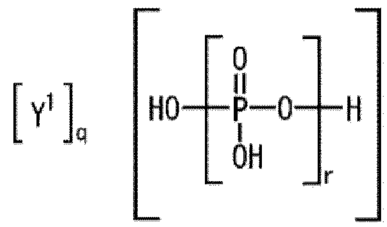

(3)

where r denotes a numeric from 1 to 100, $Y^1$ represents $[R^1R^2N(CH_2)_mNR^3R^4]$, piperazine, or diamine including a piperazine ring, $R^1$, $R^2$, $R^3$, and $R^4$, which may be the same group or different groups from one another, are each a hydrogen atom or a straight-chain or branched alkyl group having 1 to 5 carbon atoms, m is an integer from 1 to 10, and q is a numeric satisfying the relational expression, $0 < q \leq r + 2$.

As used herein, in the (poly)phosphate expressed by General Formula (1) above, triazine(poly)phosphate is used as a term representing a salt of (poly)phosphoric acid and a triazine derivative or ammonia. Also, in the (poly) phosphate expressed by General Formula (3) above, piperazine (poly)phosphate is used as a term representing a salt of (poly)phosphoric acid and piperazine or diamine including a piperazine ring.

In General Formula (1) above, the (poly)phosphate is an orthophosphate when n is 1, a pyrophosphate when n is 2, and a triphosphate when n is 3, for example.

Also, in General Formula (3) above, the (poly)phosphate is an orthophosphate when r is 1, a pyrophosphate when r is 2, and a triphosphate when r is 3, for example.

Examples of the straight-chain or branched alkyl group having 1 to 10 carbon atoms represented by $Z^1$ and $Z^2$ in General Formula (2) above include methyl, ethyl, propyl, isopropyl, butyl, secondary butyl, tertiary butyl, isobutyl, amyl, isoamyl, tertiary amyl, hexyl, cyclohexyl, heptyl, isoheptyl, tertiary heptyl, n-octyl, isooctyl, tertiary octyl, 2-ethylhexyl, nonyl, and decyl, and examples of the straight-chain or branched alkoxy group having 1 to 10 carbon atoms include groups derived from these alkyl groups. Examples of the straight-chain or branched alkyl group having 1 to 6 carbon atoms represented by $R^5$ and $R^6$ in the $-NR^5R^6$ group that may be selected as $Z^1$ and $Z^2$ include ones having 1 to 6 carbon atoms among the above-listed alkyl groups.

Specific examples of the triazine derivative represented by $X^1$ in General Formula (1) include melamine, acetoguanamine, benzoguanamine, acrylguanamine, 2,4-diamino-6-nonyl-1,3,5-triazine, 2,4-diamino-6-hydroxy-1,3,5-triazine, 2-amino-4,6-dihyroxy-1,3,5-triazine, 2,4-diamino-6-methoxy-1,3,5-triazine, 2,4-diamino-6-ethoxy-1,3,5-triazine, 2,4-diamino-6-propoxy-1,3,5-triazine, 2,4-diamino-6-isopropoxy-1,3,5-triazine, 2,4-diamino-6-mercapto-1,3,5-triazine, and 2-amino-4,6-dimercapto-1,3,5-triazine.

The phosphorus-based flame retardant preferably contains a pyrophosphate (triazine pyrophosphate, ammonium pyrophosphate) expressed by General Formula (1) above. Also, the phosphorus-based flame retardant preferably contains a pyrophosphate in which $X^1$ in General Formula (1) is melamine (melamine pyrophosphate). With this, the flame retardancy can be improved stably.

Examples of the diamine represented by $Y^1$ in General Formula (3) above include $R^1R^2N(CH_2)_mNR^3R^4$, piperazine, or a diamine including a piperazine ring. $R^1$ to $R^4$, which may be the same or different from one another, each represent a straight-chain or branched alkyl group having 1 to 5 carbon atoms.

Examples of the straight-chain or branched alkyl group having 1 to 5 carbon atoms represented by $R^1$ to $R^4$ described above include ones having 1 to 5 carbon atoms among those listed above as specific examples of the alkyl group represented by $Z^1$ and $Z^2$.

Examples of the diamine including a piperazine ring include: a compound with one or more of 2, 3, 5, and 6 positions of piperazine replaced with an alkyl group (preferably having 1 to 5 carbon atoms); and a compound with an amino group at 1 and/or 4 position of piperazine replaced with an alkyl group (preferably having 1 to 5 carbon atoms).

Specific examples of the diamine represented by $Y^1$ in General Formula (3) above include N,N,N',N'-tetramethyldiaminomethane, ethylenediamine, N,N'-dimethylethylenediamine, N,N'-diethyl ethyl enediamine, N,N-dimethylethylenediamine, N,N-diethylethylenediamine, N,N,N' ,N' -tetramethylethylenediamine, N,N,N',N' - tetraethylethylenediamine, tetramethylenediamine, 1,2-propanediamine, 1,3-propanediamine, tetramethylenediamine, pentamethylenediamine, hexamethylenediamine, 1,7-diaminoheptane, 1,8-diaminooctane, 1,9-diaminononane, 1,10-diaminodecane, piperazine, trans-2,5-dimethylpiperazine, 1,4-bis(2-aminoethyl)piperazine, and 1,4-bis(3-aminopropyl)piperazine.

The phosphorus-based flame retardant preferably contains a pyrophosphate in which $Y^1$ in General Formula (3) is piperazine (piperazine pyrophosphate). With this, the flame retardancy can be improved stably.

Also, the phosphorus-based flame retardant may contain both a (poly)phosphate expressed by General Formula (1) and a (poly)phosphate expressed by General Formula (3). Among others, the phosphorus-based flame retardant preferably contains a pyrophosphate in which $X^1$ in General Formula (1) is melamine (melamine pyrophosphate) and a piperazine (poly)phosphate expressed by General Formula (3), more preferably contains a pyrophosphate in which $X^1$ in General Formula (1) is melamine (melamine pyrophosphate) and a pyrophosphate in which $Y^1$ in General Formula (3) is piperazine (piperazine pyrophosphate). With this, the flame retardancy can be further enhanced. Note that the content ratio of these compounds may be determined appropriately.

The phosphorus-based flame retardant may contain either one or both of an orthophosphate and a pyrophosphate, in addition to the pyrophosphate. With this, the properties of the phosphorus-based flame retardant can be balanced.

The content of the phosphorus-based flame retardant in the conductive resin composition is 10 mass% or more. The content of the phosphorus-based flame retardant is 10 mass% or more, preferably 20 mass% or more, from the viewpoint of improving flame retardancy. Also, the content of the phosphorus-based flame retardant is preferably 30 mass% or less, more preferably 25 mass% or less, from the viewpoint of efficiently improving flame retardancy.

In the relationship between the contents of the coke powder and the phosphorus-based flame retardant and the flame retardancy, as shown in FIG. 3, in the range where the content of the phosphorus-based flame retardant is 0 to 30 mass% (30 mass% or less), the limiting oxygen index (LOI) exhibits linearity and is roughly kept from decreasing when the content of the coke powder is less than 20 mass%, but it does not exhibit linearity and decreases when the content of the coke powder is 20 mass% or more. In other words, while the flame retardancy improves as the content of the coke powder is higher in the range of the content of the phosphorus-based flame retardant exceeding 30 mass%, the flame retardancy improves by reducing the content of the coke powder to less than 20 mass% in the range of the content of the phosphorus-based flame retardant of 30 mass% or less. Thus, since the content of the coke powder can be reduced in the range of the content of the phosphorus-based flame retardant of 30 mass% or less, the flame retardancy can be improved efficiently. That is, the content of the phosphorus-based flame retardant of "30 mass%" can be called the change point for the decrease in flame retardancy due to addition of the coke powder.

From the results of FIGS. 1 to 3, by using the coke powder in the range "not less than 5 mass% and not more than 17 mass%" and the phosphorus-based flame retardant in the range "not less than 10 mass% and not more than 30 mass%," it is possible to obtain a synergistic effect of securing both the electromagnetic shielding property (e.g., an electric field shielding effect (SE) of 45 dB (shield factor 99%) or more) and the flame retardancy (e.g., a limiting oxygen index (LOI) of 36% or more).

The total of the contents of the coke powder and the phosphorus-based flame retardant in the conductive resin composition is preferably 15 mass% or more, more preferably 30 mass% or more, still more preferably 35 mass% or more, and preferably 47 mass% or less, from the viewpoint of securing both the electromagnetic shielding property and flame retardancy.

(Flame Retardant Aid)

The conductive resin composition of this embodiment may contain a flame retardant aid. The type of flame

retardant aid is not specifically limited, but a metal compound, such as zinc oxide, for example, may be used as the flame retardant aid used for the phosphorus-based flame retardant. By adding a metal-compound flame retardant aid, whatever type the metal compound is, the electrical conductivity of the flame retardant aid itself contributes to formation of a conductive path, whereby the electromagnetic shielding property can be improved.

The content of the flame retardant aid in the conductive resin composition is preferably not less than 0.5 mass% and not more than 5 mass% from the viewpoint of securing both the electromagnetic shielding property and flame retardancy.

The content of the flame retardant aid relative to the matrix resin (100 mass%) (the content of the flame retardant aid in the matrix resin) is preferably not less than 3 mass% and not more than 8 mass% from the viewpoint of securing both the electromagnetic shielding property and flame retardancy.

(Reinforcing Filler)

The conductive resin composition of this embodiment may contain a reinforcing filler. With addition of the reinforcing filler, a particle aggregation promoting effect is obtained by a mixture. That is, since the reinforcing filler contributes to formation of an electrically conductive path, the electromagnetic shielding property can be improved. Also, with addition of the reinforcing filler, mechanical properties can be improved.

Examples of the reinforcing filler include talc, calcium carbonate, glass fiber ((hereinafter also called "GF"), aramid fiber, and basalt fiber. These types of reinforcing filler may be used alone, or two or more types may be used in combination. As the reinforcing filler, a commercially available one can be used. Among the above types of reinforcing filler, glass fiber is preferable from the viewpoint of further improving mechanical properties and electrical conductivity.

As the glass fiber, commercially available glass fiber such as E-glass fiber and S-glass fiber can be used. These types of glass fiber may be used alone, or two or more types may be used in combination.

The mean fiber length of the glass fiber is preferably 0.5 mm or more, more preferably 1 mm or more, still more preferably 1.5 mm or more, furthermore preferably 2 mm or more. Also, the mean fiber length of the glass fiber is preferably 10 mm or less, more preferably 5 mm or less, from the viewpoint of improving moldability. Among the types of glass fiber, glass fibers of long fiber specification having a mean fiber length of 1.5 mm or more is preferable from the viewpoint of further improving mechanical properties and electrical conductivity.

The mean fiber diameter of the glass fiber is preferably 10 μm or more, more preferably 12 μm or more, from the viewpoint of improving mechanical properties. Also, the mean fiber diameter is preferably 25 μm or less, more preferably 20 μm or less, from the viewpoint of improving moldability.

The aspect ratio of the glass fiber is preferably 5 or more, more preferably 50 or more, still more preferably 100 or more, from the viewpoint of improving mechanical properties. Also, the aspect ratio of the glass fiber is preferably 700 or less, more preferably 250 or less, still more preferably 150 or less, from the viewpoint of improving moldability.

The content of the reinforcing filler in the conductive resin composition is preferably 5 mass% or more, more preferably 15 mass% or more, still more preferably 20 mass% or more, from the viewpoint of improving mechanical properties and the electromagnetic shielding property. Also, the content of the reinforcing filler is preferably 25 mass% or less from the viewpoint of improving moldability.

The total of the contents of the coke powder, the carbon fiber, and the glass fiber in the conductive resin composition is preferably 10.5 mass% or more, more preferably 30 mass% or more, from the viewpoint of improving mechanical properties and the electromagnetic shielding property. Also, the total of the contents of the coke powder, the carbon fiber, and the glass fiber is preferably 50 mass% or less from the viewpoint of improving moldability and mechanical properties and cost reduction.

(Other Conductive Material)

The conductive resin composition may contain electrically conductive materials (optional ingredients) other than the coke powder and the carbon fiber as long as the effects of the present disclosure are not impaired. Examples of other conductive materials include: carbon black; metal fiber; metal fillers such as copper powder, silver powder, nickel powder, silver-coated copper powder, gold-coated copper powder, silver-coated nickel powder, and gold-coated nickel powder; and metal-sheathed resin fillers. These conductive materials may be used alone, or two or more types may be used in combination. Among these conductive materials, carbon black is preferable.

Examples of the carbon black include acetylene black, gas black, oil black, naphthalin black, thermal black, furnace black, lamp black, channel black, roll black, disc black, and Ketjen black, depending on the raw material and the manufacturing method.

(Manufacturing Method of Conductive Resin Composition)

Next, the method for manufacturing the conductive resin composition will be described. A pellet with ingredients such as the coke powder, the phosphorus-based flame retardant, and, if necessary, the flame retardant aid and the like contained in the matrix resin is used as a masterbatch. The masterbatch containing the above ingredients mixed to have a desired formulation ratio is put into a kneading extruder. The kneading extruder is a biaxial extruder, for example. The mixture in the kneading extruder is melt-kneaded, so that the ingredients are uniformly dispersed in the matrix resin, to prepare a pellet as the masterbatch. Subsequently, ingredients such as the carbon fiber, and, if necessary, the glass fiber and other conductive materials are added to the masterbatch to have a desired formulation ratio and uniformly dispersed in the matrix resin, whereby the conductive resin composition is obtained.

<Electromagnetic Shielding Material>

(Electromagnetic Shielding Material)

The electromagnetic shielding material of this embodiment is formed of the above-described conductive resin composition by molding. This electromagnetic shielding material, made of the conductive resin composition, can exhibit both an excellent electromagnetic shielding property and flame retardancy while maintaining excellent mechanical properties and low cost.

The electromagnetic shielding material can be suitably used for covering materials used for exteriors (front, sides, rear) of a vehicle, such as a bumper, and covering materials of radar-related articles, for example. Note that the electromagnetic shielding material is not limited to the use for members of vehicles, but can also be suitably used for members required to shield electromagnetic waves, such as housings of general electronic devices and bodies of robots, for example.

(Manufacturing Method of Electromagnetic Shielding Material)

The method for manufacturing the electromagnetic shielding material is not specifically limited, but an electromagnetic shielding material having a desired shape can be obtained by a generally used molding method such as hot pressing. For example, in injection molding, the molten material (conductive resin composition) melt-kneaded in the above process is injected into a mold and cooled, to manufacture the electromagnetic shielding material. The molding method is not specifically limited, but, besides the above-described injection molding, extrusion molding, vacuum molding, compression molding, autoclave molding, and resin transfer molding (RTM), for example, may be used.

<Effects>

According to the conductive resin composition of this embodiment, since the coke powder and the carbon filter as conductive fillers are used together with the phosphorus-based flame retardant and the contents of the coke powder and the phosphorus-based flame retardant are specified, decrease in flame retardancy due to addition of the coke powder is avoided and also the particle aggregation promoting effect is obtained with addition of the phosphorus-based flame retardant. As a result, an electromagnetic shielding material exhibiting an excellent electromagnetic shielding property and flame retardancy can be obtained. Also, with the particle aggregation promoting effect, an aggregation structure (network) of the coke powder and the carbon fiber is formed in the matrix resin, and this improves the mechanical properties of the electromagnetic shielding material. Moreover, since the amounts of the coke powder and the carbon fiber used are comparatively small due to the particle aggregation promoting effect, the material cost is reduced. Therefore a low-cost electromagnetic shielding material can be obtained.

EXAMPLES

The present disclosure will be described hereinafter based on examples. It should be noted that the present disclosure is not limited to the following examples, and the examples can be modified or changed without departing from the spirit of the present disclosure. Such modifications or changes will not be excluded from the scope of the present disclosure.

<Manufacture of Conductive Resin Composition and Electromagnetic Shielding Material>

As the matrix resin, polypropylene (PP) produced by Prime Polymer Co., Ltd. (product number: J108M) was used. As the coke powder (Coke), finely crushed powder (volume mean particle diameter: 24.1 μm) of coke produced by

New Chemical Trading Co., Ltd. was used. As the phosphorus-based flame retardant, ADK STAB FP-2500S (main ingredient: melamine pyrophosphate/ piperazine pyrophosphate) produced by ADECA Corp. was used. As carbon fiber (CF) reinforced PP, PLASTRON (carbon fiber 40% blended PP, mean fiber length: approx. 0.9 mm to 4 mm, mean fiber diameter: approx. 7 μm, aspect ratio: approx. 130 to 570) produced by Daicel Polymer Ltd. was used. As glass fiber (GF) reinforced PP, HLG76B (glass fiber 60% blended PP, mean fiber length: approx. 0.9 mm to 4 mm, mean fiber diameter: approx. 17 μm, aspect ratio: approx. 53 to 230) produced by GS Caltex was used. As the flame retardant aid, zinc oxide was used.

The matrix resin and ingredients such as the coke powder (Coke), the phosphorus-based flame retardant, and, if necessary, the flame retardant aid were put into a kneading extruder at the content percentages shown in Table 1, and the ingredients were uniformly dispersed in the matrix resin, to prepare a pellet that is to be a masterbatch.

The masterbatch obtained as described above and ingredients such as the carbon fiber (CF) reinforced PP, and, if necessary, the glass fiber (GF) reinforced PP were put into an injection molding machine at the content percentages shown in Table 1 (manufacture of the conductive resin composition).

Subsequently, the conductive resin composition was injected into a one-direct-gate mold (180 mm × 175 mm × 2.5 mm) to prepare a test resin plate (electromagnetic shielding material). As the injection molding machine, one having a mold clamping force of 220 t was used. The thickness of the test resin plate was 2.5 mm. The molding conditions were as follows: the resin temperature was 220°C, the mold temperature 40°C, the number of rotations of a screw (double-flight screw) 60 rpm, the back pressure 3 MPa, the injection speed 100 mm/s, and the holding pressure 30 MPa × 15 sec.

Using the test resin plate obtained above, the mechanical properties, electromagnetic shielding property (electric field shielding effect), and flame retardancy of the electromagnetic shielding material were evaluated by the following methods. The results are shown in Table 1.

<Evaluation of Mechanical Properties>

(Bending Strength and Bending Elasticity)

A three-point bending test was performed for the test resin plate obtained above according to JIS K 7171, to measure the bending strength and the bending elasticity as the bending properties. As the testing machine, a precision universal tester (Autograph AG-5kNX manufactured by Shimadzu Corp.) was used. The measurement was performed at a displacement rate of 2 mm/min in an environment of 23°C and 50 RH%.

<Evaluation of Electromagnetic Shielding Property (Electric Field Shielding Effect)>

The electric field shielding effect of the test resin plate obtained above was evaluated by the KEC method using the electromagnetic shielding effect measuring device developed by KEC Electronic Industry Development Center. An electromagnetic wave having a frequency of 1.7 MHz was used. The measurement was performed in an atmosphere of a temperature of 25°C and a relative humidity of 30 to 50 %.

<Evaluation of Flame Retardancy>

The flame retardancy of the test resin plate obtained above was evaluated based on the limiting oxygen index (LOI) according to JIS K 7201. It was also evaluated by a cone calorie meter test according to JIS S 1316.

(Table 1)

| Conductive resin composition | | | Example 1 | Example 2 | Example 3 | Example 4 | Com.Ex.1 | Com.Ex.2 | Com.Ex.3 | Com.Ex.4 | Com.Ex.5 | Com.Ex.6 | Com.Ex.7 |
|---|---|---|---|---|---|---|---|---|---|---|---|---|---|
| Number in Figure | | | ③' | ③ | ④ | ⑤ | ① | ② | ⑥ | ⑦ | ⑧ | ⑨ | ⑩ |
| Content of ingradients [wt%] | Coke | | 5 | 10 | 14 | 17 | 0 | 10 | 20 | 25 | 10 | 20 | 30 |
| | CF | | 2 | 2 | 2 | 2 | 0 | 0 | 0 | 0 | 2 | 2 | 2 |
| | GF | | 22 | 22 | 18 | 15 | 0 | 0 | 0 | 0 | 0 | 0 | 0 |
| | Phosphorus-based flame retardant | | 23 | 23 | 23 | 23 | 20 | 20 | 20 | 20 | 0 | 0 | 0 |
| | Flame retardant aid | | 2 | 2 | 2 | 2 | 0 | 0 | 0 | 0 | 0 | 0 | 0 |
| | Matrix resin | | 46 | 41 | 41 | 41 | 80 | 70 | 60 | 55 | 88 | 78 | 68 |
| Content of Coke+CF [wt%] | | | 7 | 12 | 16 | 19 | 0 | 10 | 20 | 25 | 12 | 22 | 32 |
| Content of Coke+CF+GF [wt%] | | | 29 | 34 | 34 | 34 | 0 | 10 | 20 | 25 | 12 | 22 | 32 |
| Content of Coke+phosphorus-based flame retardant [wt%] | | | 28 | 33 | 37 | 40 | 20 | 30 | 40 | 45 | 10 | 20 | 30 |
| Content of flame retardant aid to matrix resin [wt%] | | | 4 | 5 | 5 | 5 | 0 | 0 | 0 | 0 | 0 | 0 | 0 |
| Mechanical properties | Bending elasticity [MPa] | | - | 9478 | 8090 | 7501 | - | - | - | - | - | - | - |
| | Bending strength [MPa] | | - | 134.7 | 120.7 | 11.9 | - | - | - | - | - | - | - |
| Flame retardancy | Limiting oxygen index(LOI)[%] | | - | 37 | 37 | 36 | 38 | 38 | 31 | 27 | (below 36) | (below 36) | (below 36) |
| | Cone calorie meter [MJ/m$^2$] | Gross calorific value | - | 23 | 23 | 33 | 81 | 93 | - | 99 | - | - | - |
| | | Max.heat release rate | - | 90 | 97 | 154 | 231 | 292 | - | 273 | - | - | - |
| | | Aveheat release rate | - | 80 | 81 | 119 | 129 | 149 | - | 185 | - | - | - |
| Electromagnetic shielding property | | 1.7MHz electric field shielding effect [dB] | 47.1 | 52.9 | 56.4 | 60.7 | 0.0 | (below 45) | (below 45) | (below 45) | 8.8 | 16.0 | 25.1 |

As described above, the conductive resin composition according to the present disclosure is useful as the molding materila for an electromagnetic shielding material and the like.

## Claims

1. A conductive resin composition containing matrix resin, coke powder, carbon fiber, and a phosphorus-based flame retardant including (poly)phosphate, wherein

   a volume mean particle diameter of the coke powder is not less than 1 μm and not more than 500 μm,
   a content of the coke powder in the conductive resin composition is not less than 5 mass% and not more than 17 mass%,
   an aspect ratio of the carbon fiber is not less than 3 and not more than 1700,
   a content of the carbon fiber in the conductive resin composition is not less than 0.5 mass% and not more than 5 mass%, and
   a content of the phosphorus-based flame retardant in the conductive resin composition is not less than 10 mass%.

2. The conductive resin composition of claim 1, wherein
   the content of the phosphorus-based flame retardant in the conductive resin composition is not more than 30 mass%.

3. The conductive resin composition of claim 1, wherein
   the phosphorus-based flame retardant is a phosphorus-based flame retardant satisfying

$$8.0 \times 10^{-4} \le F / N \le 20.0, F \le 21.0$$

   where F is a content (ppm) of iron element, and N is a content (ppm) of sodium element, in the phosphorus-based flame retardant, measured according to the following procedure:

   mixing the phosphorus-based flame retardant as a sample in a 1M nitric acid aqueous solution, agitating the solution for 24 hours at room temperature 25°C, and then subjecting the solution to a membrane filter, to prepare a measurement solution; and
   measuring contents of the iron element and the sodium element in the resultant measurement solution by ICP optical emission spectroscopy.

4. The conductive resin composition of claim 3, wherein
   the phosphorus-based flame retardant is a phosphorus-based flame retardant including at least a pyrophosphate, among the group of (poly)phosphate consisting of orthophosphates, pyrophosphates, and polyphosphates in which n is 3 or more or r is 3 or more, expressed by General Formula (1) or General Formula (3) below

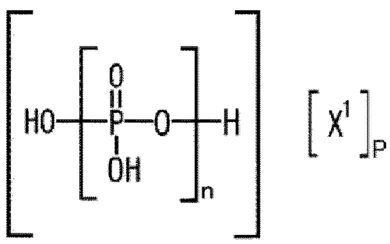

(1)

   where n denotes a numeric from 1 to 100, $X^1$ represents ammonia or a triazine derivative expressed by General Formula (2) below, and p is a numeric satisfying a relational expression, $0 < p \le n + 2$,

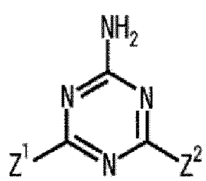

(2)

where $Z^1$ and $Z^2$, which may be the same or different from each other, represent a group selected from the group consisting of a $-NR^5R^6$ group, a hydroxyl group, a mercapto group, a straight-chain or branched alkyl group having 1 to 10 carbon atoms, a straight-chain or branched alkoxy group having 1 to 10 carbon atoms, a phenyl group, and a vinyl group, and $R^5$ and $R^6$ independently represent a hydrogen atom, a straight-chain or branched alkyl group having 1 to 6 carbon atoms, or a methylol group,

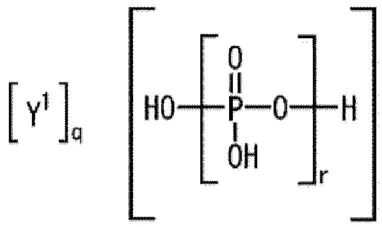 (3)

where r denotes a numeric from 1 to 100, $Y^1$ represents $[R^1R^2N(CH_2)_mNR^3R^4]$, piperazine, or diamine including a piperazine ring, $R^1$, $R^2$, $R^3$, and $R^4$, which may be the same or different from one another, are each a hydrogen atom or a straight-chain or branched alkyl group having 1 to 5 carbon atoms, m is an integer from 1 to 10, and q is a numeric satisfying a relational expression, $0 < q \leq r + 2$.

**5.** The conductive resin composition of claim 1, further containing

a flame retardant aid,
wherein
a content of the flame retardant aid in the conductive resin composition is not less than 0.5 mass% and not more than 5 mass%.

**6.** The conductive resin composition of claim 5, wherein
the flame retardant aid is zinc oxide.

**7.** The conductive resin composition of claim 1, further containing

a reinforcing filler,
wherein
a content of the reinforcing filler in the conductive resin composition is not less than 5 mass% and not more than 40 mass%.

**8.** The conductive resin composition of claim 7, wherein
the reinforcing filler is at least one type selected from the group consisting of talc, calcium carbonate, glass fiber, aramid fiber, and basalt fiber.

**9.** An electromagnetic shielding material using the conductive resin composition of any one of claims 1 to 8.

FIG.1

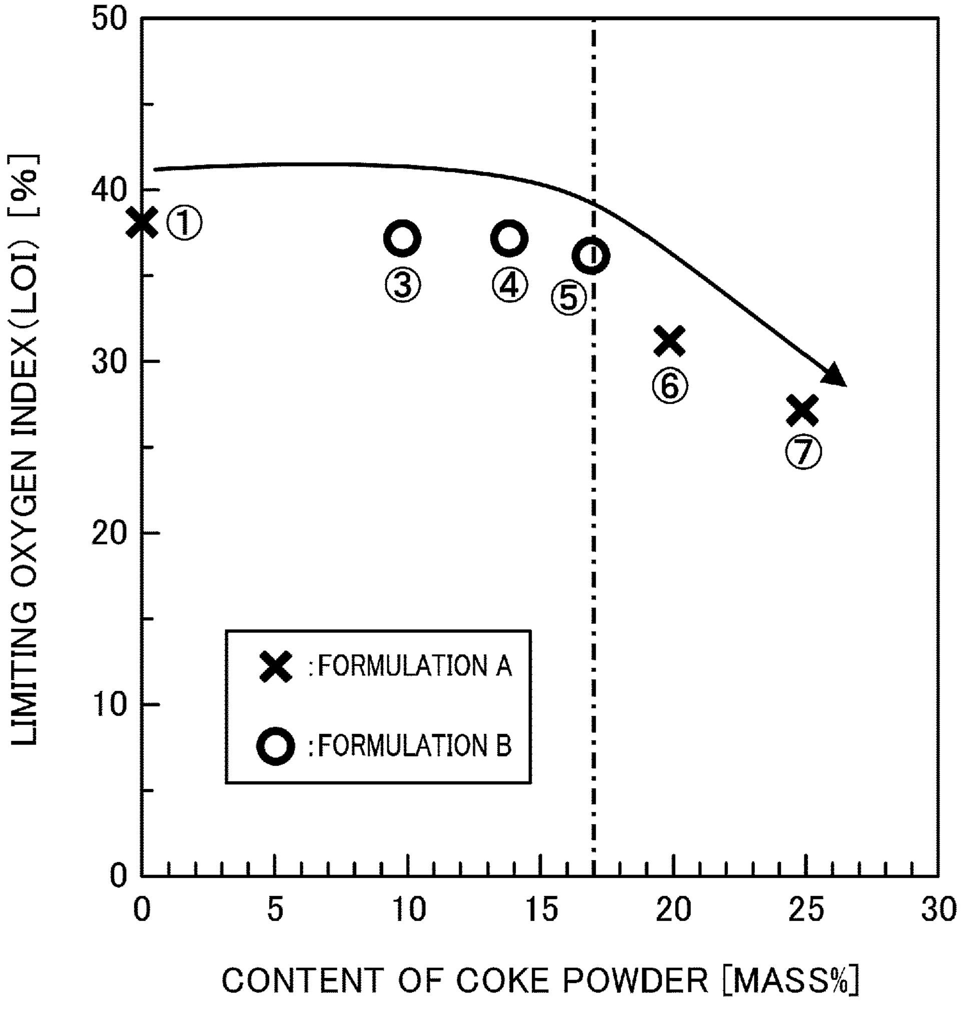
50
40
30
20
10
0
LIMITING OXYGEN INDEX (LOI) [%]
①
③
④
⑤
⑥
⑦
: FORMULATION A
: FORMULATION B
0
5
10
15
20
25
30
CONTENT OF COKE POWDER [MASS%]

FIG.2

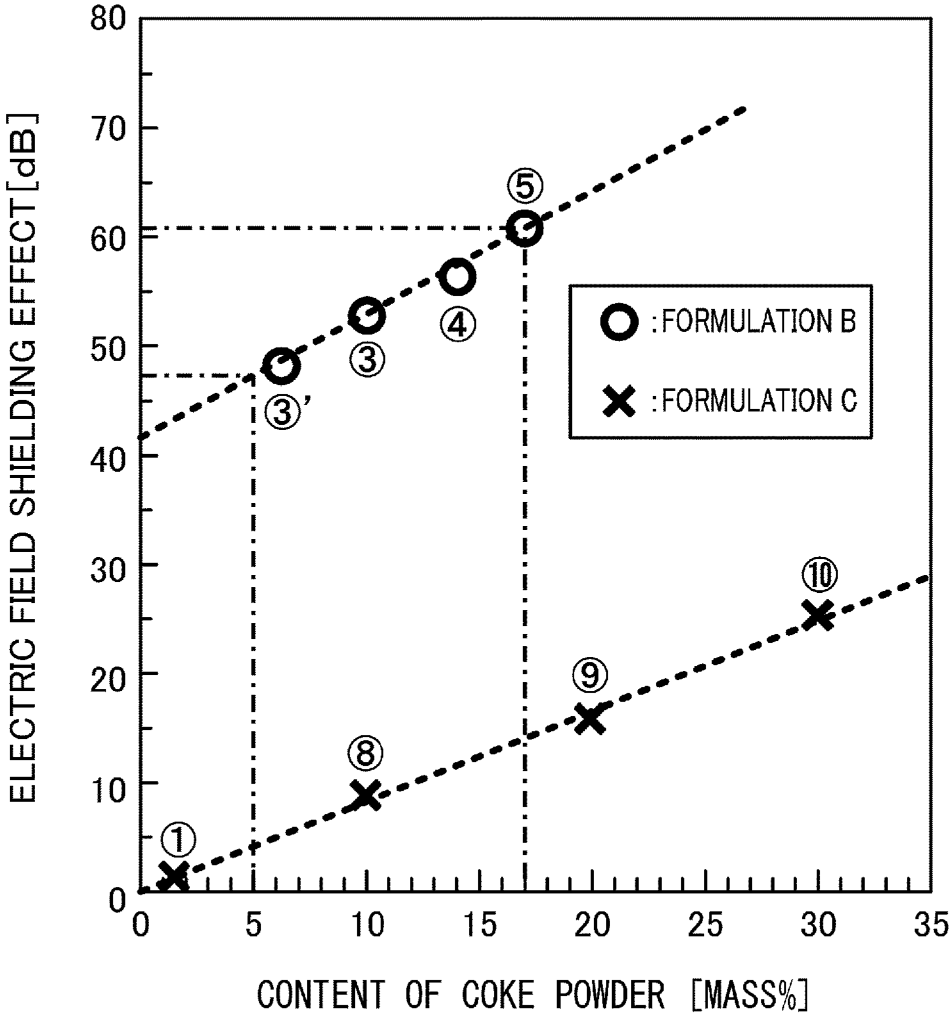
ELECTRIC FIELD SHIELDING EFFECT[dB]
80
70
60
50
40
30
20
10
0
0
5
10
15
20
25
30
35
CONTENT OF COKE POWDER [MASS%]
:FORMULATION B
:FORMULATION C
①
③'
③
④
⑤
⑧
⑨
⑩

FIG.3

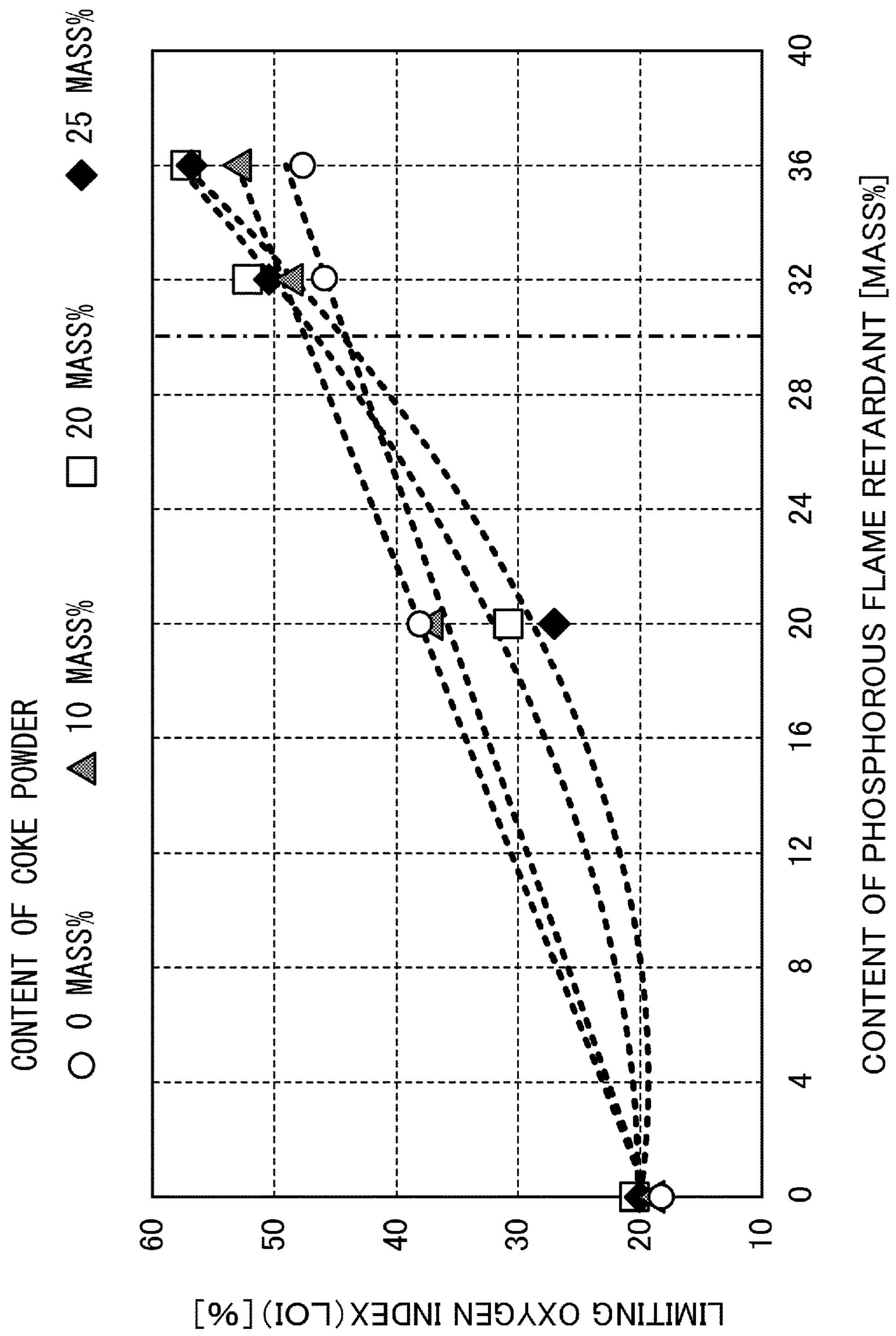
CONTENT OF COKE POWDER
○ 0 MASS%
▲ 10 MASS%
□ 20 MASS%
◆ 25 MASS%
LIMITING OXYGEN INDEX (LOI) [%]
60
50
40
30
20
10
0
4
8
12
16
20
24
28
32
36
40
CONTENT OF PHOSPHOROUS FLAME RETARDANT [MASS%]

Europäisches Patentamt
European Patent Office
Office européen des brevets

# EUROPEAN SEARCH REPORT

Application Number
EP 24 19 9698

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2021/307217 A1 (MIYANAGA TOSHIAKI [JP] ET AL) 30 September 2021 (2021-09-30) * paragraphs [0020], [0055], [0057]; claims 1, 3, 7, 8, 11; figures 3, 7 * | 1-9 | INV. C08K3/04 C08K3/22 C08K3/32 C08K5/52 C08K7/06 C08K7/14 C08L23/12 |
| Y | ZHI HU ET AL: "Application of a piperazine pyrophosphate intumescent flame retardant in thin-walled glass fiber-reinforced polypropylene materials", JOURNAL OF APPLIED POLYMER SCIENCE, JOHN WILEY & SONS, INC, US, vol. 140, no. 40, 31 July 2023 (2023-07-31), pages 1-13, XP072496416, ISSN: 0021-8995, DOI: 10.1002/APP.54498 * Abstract, Conclusion; figures 5(a),5(b); table 3 * | 1-9 | |
| Y | EP 3 957 702 A1 (ADEKA CORP [JP]) 23 February 2022 (2022-02-23) * paragraphs [0124], [0154] - [0156]; claims 1, 3, 7, 9, 13-15; examples; table 1 * | 1-9 | TECHNICAL FIELDS SEARCHED (IPC) C08K |
| A | JP 2012 158648 A (JAPAN POLYPROPYLENE CORP) 23 August 2012 (2012-08-23) | 1-9 | |

The present search report has been drawn up for all claims

1

| Place of search | Date of completion of the search | Examiner |
|---|---|---|
| Munich | 24 February 2025 | Lohner, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 24 19 9698

This annex lists the patent family members relating to the patent documents cited in the above-mentioned European search report. The members are as contained in the European Patent Office EDP file on
The European Patent Office is in no way liable for these particulars which are merely given for the purpose of information.

24-02-2025

| Patent document cited in search report | Publication date | Patent family member(s) | Publication date |
|---|---|---|---|
| US 2021307217 A1 | 30-09-2021 | CN 113462071 A | 01-10-2021 |
| | | EP 3890465 A1 | 06-10-2021 |
| | | JP 7393279 B2 | 06-12-2023 |
| | | JP 2021161193 A | 11-10-2021 |
| | | US 2021307217 A1 | 30-09-2021 |
| EP 3957702 A1 | 23-02-2022 | BR 112021023844 A2 | 26-04-2022 |
| | | CN 114008121 A | 01-02-2022 |
| | | EP 3957702 A1 | 23-02-2022 |
| | | JP 6845383 B1 | 17-03-2021 |
| | | JP 2021091914 A | 17-06-2021 |
| | | JP WO2021020140 A1 | 13-09-2021 |
| | | KR 20220025169 A | 03-03-2022 |
| | | TW 202112755 A | 01-04-2021 |
| | | US 2022220386 A1 | 14-07-2022 |
| | | WO 2021020140 A1 | 04-02-2021 |
| JP 2012158648 A | 23-08-2012 | JP 5526049 B2 | 18-06-2014 |
| | | JP 2012158648 A | 23-08-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2023173568 A
- JP 2021161193 A